# FASCICULE DE BREVET EUROPEEN

(11) **EP 3 191 853 B1**
(45) Date de publication et mention de la délivrance du brevet: **14.10.2020**
(21) Numéro de dépôt: 15766914.4
(22) Date de dépôt: 03.09.2015
(51) Int. Cl.: G01R 19/00, H03F 1/34

(54) **DISPOSITIF POUR LA MESURE DE COURANT**
STROMMESSVORRICHTUNG
CURRENT-MEASUREMENT DEVICE

(30) Priorité: 10.09.2014 FR 1458486
(43) Date de publication de la demande: 19.07.2017
(73) Titulaire: Commissariat à l'Énergie Atomique et aux Énergies Alternatives, 75015 Paris (FR)
(72) Inventeur: BODEN, Robert, 91410 Dourdan (FR)
(74) Mandataire: Cabinet Camus Lebkiri
(86) Numéro de dépôt international: PCT/FR2015/052330
(87) Numéro de publication internationale: WO 2016/038281

(56) Documents cités:
- EP-A2- 0 436 777
- WO-A1-2010/109347
- US-A- 5 770 956
- US-A1- 2005 105 309
- US-A1- 2005 105 310
- US-A1- 2014 174 145

## Description

### DOMAINE TECHNIQUE DE L'INVENTION

L'invention se rapporte à un dispositif pour la mesure de courants, et plus particulièrement un dispositif pour la mesure de courant par intégration, et plus spécifiquement la mesure de très faibles courants, proches du femto ampère. En outre, ce dispositif est préférentiellement destiné à interfacer une chambre d'ionisation, utilisée pour les détecteurs de radioprotection ou de mesure de dose à des fins médicales, qui procède par intégration. Ce dispositif pouvant en outre s'appliquer à la mesure de courants au sein de très fortes résistances, ou encore la mesure des résistances de fuite des isolants ou isolateurs.

### ETAT DE LA TECHNIQUE ANTERIEURE

La mesure de courant par intégration est privilégiée pour la mesure de très faibles courants, pouvant descendre jusqu'au femto ampère avec des temps d'intégration de l'ordre de la minute pour une mesure de quelques fA.

La mesure de rayonnements ionisants peut être réalisée au moyen de trois grandes familles de dispositifs : les chambres d'ionisation, les compteurs proportionnels et les compteurs Geiger.

Une chambre d'ionisation est constituée de deux surfaces conductrices, planes ou coaxiales, séparées par un diélectrique gazeux. Ces deux surfaces conductrices sont polarisées par une tension continue de l'ordre de 100v/cm. Les particules ou rayonnements ionisants génèrent des paires d'ions (électron-noyau), l'ensemble se comportant comme un générateur de courant, de résistance interne supérieure à 10¹⁵ Ohms. Le faible courant généré est proportionnel à l'ionisation. Un diélectrique composé d'air, à pression atmosphérique, génère ainsi, pour chaque unité de volume d'un dm3, un courant de 10⁻¹⁴ A/µGy/h. Certaines chambres d'ionisation sont colimatées par des blindages en plomb (laboratoire de métrologie) pour ne détecter que ce qui vient d'une direction ou d'un volume donné. En effet, le volume à prendre en compte est celui délimité par la zone irradiée, qui peut être plus petit que le volume total compris entre les électrodes. Si on augmente la pression de l'air, la sensibilité croit en proportion puisqu'elle dépend de la quantité de molécules de gaz dans le volume de mesure séparant les électrodes. La chambre générant un courant proportionnel à l'irradiation, l'impédance d'entrée du circuit d'acquisition doit être négligeable devant celle de la chambre d'ionisation, afin de ne pas introduire de chute de tension.

Le volume de diélectrique détermine la sensibilité de la chambre. Selon les applications industrielles actuelles, les sensibilités des chambres d'ionisation sont de plusieurs types :
- pour des champs très localisés comme en curiethérapie, de l'ordre du cm³;
- pour des contrôles portatifs (type dispositif Babyline ™) un demi dm³ (voire moins si l'air est sous pression) pour garder la maniabilité ;
- pour les chambres-gaz, visant à mesurer les rayonnements émis par un gaz radioactif que l'on fait circuler entre les deux électrodes de la chambre, le volume est de l'ordre du dm³ à une dizaine de dm³
- pour les chambres d'irradiation destinées à la mesure de l'irradiation ambiante d'un bâtiment nucléaire, où les sources peuvent être multiples et sont généralement éloignées, il importe d'en capter le plus possible. Le volume est alors de quelques dm³ à plusieurs dizaines de dm³.

L'objet de l'invention ne réside toutefois pas dans ces détecteurs eux-mêmes, mais dans un dispositif de mesure par intégration de très faibles courants, dont une application préférentielle est de constituer l'électronique d'entrée apte à être placée entre ces chambres de détection de rayonnements et des moyens de comptage ou de visualisation réalisés en électronique plus conventionnelle (par exemple C-Mos). Après un bref rappel de ces détecteurs, on s'attachera donc à l'électronique qui leur est associée dans l'art antérieur, et à ses contraintes fonctionnelles.

Une chambre d'ionisation suppose que les deux électrodes sont polarisées par un générateur de tension annexe, portées à une différence de potentiel allant de quelques dizaines de volts à plusieurs centaines de volts. Les tensions de polarisation les plus usuelles pour les détecteurs portatifs à chambre d'ionisation sont de quelques centaines de volts. Lorsque ces chambres d'ionisation sont soumises à un flux de particules ou de rayonnements ionisants, des paires de charges de signes opposés prennent naissance dans le volume du matériau diélectrique gazeux, et sont attirées par la tension de polarisation vers l'électrode de signe contraire à leur charge.

Le terme de « chambre d'ionisation » est un terme générique qui peut aussi désigner la famille de détecteurs composée des chambre d'ionisation proprement dites, des compteurs proportionnels et des compteurs Geiger. Dans ce qui suit, on n'utilisera cette expression que pour désigner les chambres d'ionisation proprement dites.

Ces chambres d'ionisation présentent une très bonne proportionnalité entre l'énergie déposée par des particules ou des rayonnements ionisants traversant la chambre et le très faible courant qui en résulte, d'où leur application en métrologie. Leurs dérives en fonction de la température et de la pression, sont bien connues et reproductibles. Pour exploiter ces possibilités, il convient donc de les interfacer par un circuit électronique ayant des courants de fuite extrêmement faibles, et stables dans le temps. Dans ce mode de fonctionnement, il n'est pas nécessaire que la tension de polarisation soit très stable, la réponse de la chambre est plate et varie donc très peu si la tension de polarisation varie. Par contre, des valeurs si faibles sont presque toujours mesurées par intégration, et c'est le montage intégrateur qui exige une très grande stabilité de la tension d'alimentation (<10⁻⁴). En effet, ce montage comporte un condensateur C dont la valeur, par exemple 100 pF, constitue la capacité d'intégration, en série avec la résistance de protection. Le circuit intègre donc dans le temps la charge Q=CV et la tension V aux bornes du condensateur C représente l'intégrale du courant dans le temps. Mais si la tension de polarisation varie, cette variation de tension de polarisation est répartie entre la capacité parasite de la chambre d'ionisation et la capacité C de l'intégrateur. Une mesure par intégration exige donc une stabilité de la tension de polarisation la plus grande possible, ce qui correspond dans la plupart des applications à meilleure que 10⁻⁴. La tension d'alimentation pourra être moins stable si la capacité de l'intégrateur est grande par rapport à la capacité parasite de la chambre d'ionisation.

Lorsque les charges produites sont plus nombreuses et qu'on souhaite une lecture instantanée, on n'utilise pas de circuit intégrateur mais un simple amplificateur monté en transimpédance avec une résistance pure.

Un compteur proportionnel utilise une chambre d'ionisation en principe identique, polarisée avec une tension plus élevée de manière à amplifier les charges récoltées (en pratique, une optimisation conduit à une construction de la chambre un peu différente). Les électrodes collectent ainsi plus de charges que celles initialement formées par les rayonnements ionisants. Chaque interaction produit une impulsion de courant qui est comptabilisée (comptage non plus de charges mais d'impulsions). Dès lors l'électronique ne mesure plus par intégration mais par amplification simple et comptage d'impulsion. Comme ces charges sont fortement amplifiées au sein de la chambre par un coefficient dépendant de la tension de polarisation. Celle-ci doit donc être très stable comme dans le cas précédent. Dans ce cas, ce nombre de charges collectées reste, après amplification, proportionnel à l'énergie déposée par le rayonnement incident.

Un compteur Geiger utilise une chambre d'ionisation polarisée à tension encore plus forte que dans le cas précédent du compteur proportionnel, au point que la moindre interaction déclenche un phénomène d'avalanche de charges électriques sur les électrodes, ce qui produit une impulsion. Cette décharge sera stoppée par la chute de la tension de polarisation occasionnée par l'avalanche à travers une résistance série, et par l'utilisation de certain gaz ayant un effet « extincteur ».

La stabilité de la tension d'alimentation influe beaucoup moins. Chaque interaction produit une impulsion de courant de même amplitude qui est comptabilisée (seul le nombre d'impulsions porte une information liée à l'ionisation de la chambre). Ce type de mesure ne permet pas de différencier l'énergie des rayonnements ionisants incidents.

L'électronique de détection n'intègre pas, et est encore plus simple que celle d'une chambre proportionnelle en raison de l'amplitude élevée du signal de la chambre. Elle réalise essentiellement un simple comptage d'impulsions, dont les caractéristiques permettent le déclenchement direct de compteurs très élémentaires.

Pour revenir aux chambres d'ionisation, la mesure de courants de l'ordre de quelques femto ampères de manière stable, voire moins, dans un temps raisonnable impose la satisfaction simultanée de contraintes parfois contradictoires, en particulier si l'on veut de grandes plages de mesure. L'expression « temps raisonnable » signifie en pratique de l'ordre de la seconde pour un appareil portatif manipulable dans des zones potentiellement dangereuses pour l'opérateur, ou de l'ordre de plusieurs dizaines de secondes pour une métrologie plus précise.

On rappelle qu'un circuit de mesure par intégration est prévu pour être configuré alternativement en deux états de durées très inégales :
- un état de mesure, plus long, où le circuit intègre le signal présenté à son entrée au moyen d'une capacité d'intégration, et
- un état de réinitialisation, beaucoup plus bref, qui remet la capacité d'intégration dans l'état de charge où elle se trouvait au moment de commencer la mesure par intégration. Selon l'art antérieur, cette réinitialisation correspond à une décharge de la capacité d'intégration. Selon l'invention, cette réinitialisation consiste à remettre l'état de charge initial Qo pour effectuer une mesure par intégration dans les meilleures conditions. Si par exemple le courant à mesurer tend à décharger la capacité d'intégration, le dispositif selon l'invention comporte un générateur de courant apte à placer ce condensateur dans son état de charge maximal compatible avec les tensions d'alimentation, afin de bénéficier de la plage de mesure la plus étendue possible, et cela sans avoir à inverser le signal. Nous définissons la réinitialisation comme la remise de la capacité d'intégration dans l'état de charge Q₀.

Cette réinitialisation, à l'instant où elle est établie, produit en sortie d'un premier amplificateur une tension V_{Min} dite de seuil bas, dont la valeur absolue est sensiblement égale à une première extrémité de l'échelle de mesure de tensions que peut accepter l'entrée analogique du microcontrôleur. On définit alors une tension V_{Max} dite de seuil haut dont la valeur absolue est l'autre extrémité de l'échelle de mesure du microcontrôleur.

Parmi les contraintes figurent également le choix de la valeur du condensateur servant de capacité d'intégration. Cette capacité doit être à très faible perte et d'une grande stabilité dans le temps et en fonction de la température, La capacité sera généralement utilisée aux basses fréquences (< 10 Hz). La valeur de la capacité dépend du courant à mesurer et est de l'ordre de quelques pF à quelques nF selon la plage de mesures. Les capacités de type Styroflex (copolymère de Styrène et de butadiène en feuille mince métallisée) conviennent bien pour ce type de condensateur (que l'on appellera parfois, par métonymie, une capacité, selon un usage très fréquent en électronique). Les condensateurs au mica sont très stables, mais leur courant de fuite sont plus importants et leur usage est déconseillé pour des temps d'intégration très longs, Les temps d'intégration peuvent varier de quelques ms à plusieurs heures.

La cadence de charge/décharge est également un paramètre critique. Si les décharges sont très fréquentes (plusieurs décharges /sec), la décharge ne peut être faite par commutation mécanique, et impose l'emploi de moyens électroniques de commutation. Or il n'existe actuellement aucun dispositif semiconducteur dont le rapport entre la résistance à l'état passant et à l'état bloquée est suffisamment grand pour qu'un tel circuit ne parasite pas le processus d'intégration d'un courant de l'ordre du femto ampère dans des proportions rédhibitoires.

En outre, la cadence de charges/décharges dépend de l'intensité du courant à mesurer. S'il varie dans de larges proportions, le compromis optimal sera encore plus délicat à trouver.

Pour revenir aux chambres d'ionisation, leurs circuits électroniques de mesure par intégration sont de trois types selon qu'il s'agisse d'une utilisation pour mesure de radioprotection, pour mesure métrologique de haute précision ou pour mesure en radiologie portable.

### Electroniques de mesure de courant en Radioprotection.

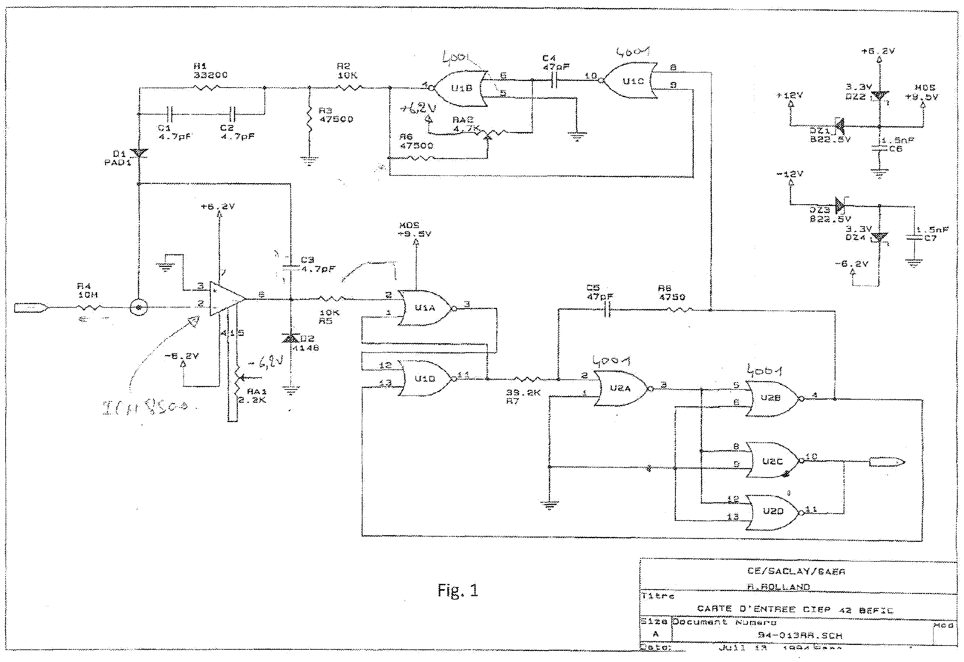

Par exemple : La CIEP 42 est une chambre d'ionisation fixe de quelques litres, conçue pour la radioprotection d'un bâtiment et non à des fins métrologiques. Cette chambre a une électronique dédiée dont le schéma est joint en figure 1. Elle contourne les problèmes délicats de sensibilité et de la stabilité à de très faibles courants en remplaçant les mesures d'amplitude par des mesures temporelles selon le processus qui suit.

La chambre est assimilable à un générateur de courant, ce courant étant quasi exclusivement dû à l'ionisation du diélectrique (air). Elle est connectée au circuit via la résistance de protection R4 de 10 MOhms. Le circuit de la figure 1 reçoit le courant résultant des charges générées dans la chambre. Elles sont toujours de même signe, fonction de la polarisation de la chambre. Après avoir traversé la résistance de protection de 10 MOhms, elles arrivent sur l'entrée « moins » d'un amplificateur opérationnel (AOP en français, OA pour Operationnal Amplifier en anglais) dont l'entrée « plus » est à la masse. Un condensateur C3, de très faible valeur (4,7 pF) constitue la capacité d'intégration qui transforme cet AOP en intégrateur. En sortie, une diode de protection interdit qu'en cas de problème un signal négatif ne dégrade les entrées du circuit logique aval.

Le condensateur d'intégration se charge en fonction du courant venant de la chambre d'ionisation. Il en résulte la nécessité de réaliser électroniquement un cycle de décharge et remise en charge par le courant à mesurer. La commande de ce cycle est elle aussi électronique : les bascules logiques U déclenchent ce cycle dès qu'un seuil de tension est atteint, et la décharge est effectuée par la porte U1B via un réseau RC qui rend passante la diode D1. Dans la plage d'utilisation, le nombre de cycles de charge-décharge peut varier de quelques décharges/h à 70000 décharges/s.

Le signal exploité finalement est la sortie 10 de la porte U2C qui délivre une impulsion à chaque cycle de décharge. Un dispositif aval associe à chaque cadence de charge/décharge une valeur de l'intensité émise initialement par la chambre. Ce circuit est adapté à des irradiations couramment rencontrées en installations nucléaires. Le but premier de ce dispositif est de faire de la détection et non de la métrologie. Ce type de fonctionnement par impulsion interdit de connaître l'intensité à un instant t : on ne dispose d'une information représentative qu'aux instants où un cycle de décharge s'enclenche. Entre deux cycles, il est impossible de savoir ce qui s'est passé depuis la fin du cycle précédent.

D'autre part la diode D1 est du type PAD 1 à faible courant de fuite ; mais ce courant est tout de même de l'ordre de quelques dizaines de fA, ce qui représente beaucoup lorsqu'on veut mesurer avec précision un courant de quelques fA.

Enfin un tel montage est sensible aux dérives, notamment thermiques. En particulier, la diode D1 (PAD 1) a un très faible courant de fuite, inférieur au pA, mais celui-ci est quand même égal ou supérieur à 20 fA. En réalité, il est minimisé par une légère polarisation de cette diode, qui optimise ; mais cette polarisation est très sensible à la température, dont la moindre variation détruit cette optimisation et fait varier le courant de fuite. Là encore, cela ne permet pas d'espérer une mesure de l'ordre de quelques fA, et stable.

Le bruit de fond mesuré par cette électronique et de l'ordre de deux µgray par heure, c'est à dire environ 20 à 40 fois le bruit de fond ambiant naturel en région parisienne. L'essentiel de ce bruit est généré volontairement par adjonction d'une source radioactive de Cs137 placé à proximité de la chambre. Ceci est destiné à générer un nombre d'impulsions suffisant pour s'assurer en permanence du bon fonctionnement du système, puisqu'il doit fonctionner sans le contrôle d'un opérateur.

Ce circuit dont le fonctionnement intégrateur repose sur une charge systématiquement complète d'une faible capacité dont la valeur de crête envoie une impulsion, le séquencement des diverses impulsions déterminant le signal de sortie Z est pratique pour donner un signal d'alerte au-dessus d'un certain seuil (apte à atteindre 70 000 charges/décharges par seconde. Il reste opérationnel en cas de très forts débits de dose incompatibles avec la vie humaine en cas d'accident nucléaire) et permet par exemple de réagir à des niveaux plus bas pour déclencher l'évacuation des personnels. En revanche, il ne constitue pas un véritable amplificateur intégrateur car ce n'est pas le niveau de charge analogique de la capacité d'intégration qui détermine le signal de sortie. C'est pourquoi ce système ne peut être utilisé en métrologie, notamment pour la mesure précise et stable de courants de l'ordre du fA, pour les raisons suivantes :
- comme il ne travaille pas en intégration d'une grandeur analogique mais par simple comptage d'impulsions, chacune correspondant à un certain nombre de pico coulombs, il n'y a aucun moyen de connaitre de manière continue la mesure du courant entre deux impulsions ; or une telle mesure continue du courant constitue l'intérêt essentiel d'une chambre d'ionisation utilisée en métrologie.
- il requiert un ajustement du courant de fuite qui dépend forcément de la dispersion des composants, de leur vieillissement et surtout de la température ambiante ; plus généralement, ces courants de fuites sont importants et difficiles à maîtriser
- afin de minimiser les artefacts, l'AOP est à très haute impédance d'entrée de l'ordre de 10¹⁴ ohms, or de tels composants sont extrêmement sensibles aux champs électrostatiques, imposent une mise en œuvre complexe et coûteuse (bracelets reliés au plan de travail et à la terre) et le prix du composant lui-même est élevé (environ 40 à 50E pièce)
- les courants d'entrées de fuite sont de l'ordre de quelques 10 fA mais la sortie peut fluctuer avec la température, notamment par glissement du point de fonctionnement de la diode D1
- Une impulsion correspond à quelques pico coulombs. Mais le dispositif ne permet pas de suivre l'évolution entre deux impulsions. Si les doses sont très faibles, la succession des impulsions de sortie peut dépasser plusieurs dizaines de minutes. Dans ce cas le signal se confondrait avec le bruit si le constructeur n'avait placé dans la chambre d'ionisation elle-même une micro source de césium 137 destinée à générer un signal minimal de référence, globalement connu, mais avec une précision insuffisante pour qu'on le déduise du signal utile.

Ce dispositif est donc pratique pour donner un signal d'alerte, mais il ne peut convenir pour de la métrologie, notamment pour les très faibles doses.

Une variante en a été donnée par la Haute Ecole d'Ingénierie et de Gestion du Canton de Vaud (HEIG-VD), en Suisse, et publiée dans la Revue Polytechnique de novembre 2013. (voir http://www.polymedia.ch/RpArticles/view/336). Le principe est le même : au-delà d'un certain seuil de chargement de la capacité d'intégration, un comparateur émet une impulsion représentant un incrément de comptage, et cette impulsion est aussi utilisée comme réinitialisation par court-circuitage de la capacité d'intégration, comme dans le CIEP 42. Partageant le même principe, il partage aussi les inconvénients ci-dessus qui découle directement de ce principe. A côté de cela, un perfectionnement très complexe a été introduit pour diminuer les « principales perturbations » qui seraient « de type électromagnétiques ». Selon notre expérience, il n'en est rien et on est fondés à considérer que ces perturbations qui affectent leur circuit résulte de l'utilisation d'un interrupteur statique (à semiconducteur) dont les courants de fuite à l'état ouvert sont importants vis-à-vis des courants à mesurer. Ceci pour court-circuiter la capacité d'intégration. Pour limiter ce problème, le dispositif ajoute un étage d'inversion périodique des électrodes du courant à mesurer, à une fréquence non mentionnée mais vraisemblablement synchronisée sur les impulsions de réinitialisation. Cela impose de faire un certain nombre de mesures avec ce courant dans un certain sens, puis un nombre équivalent de mesures avec le sens opposé. Ce perfectionnement introduit donc une nouvelle contrainte : le courant à mesurer doit être rigoureusement stable pendant 60 secondes. Ceci ne correspond pas du tout aux conditions d'une mesure du courant d'une chambre d'ionisation (au sens large), où le mesurande évolue bien entendu librement et continuellement.

### Electroniques de mesure de courant en métrologique de haute précision.

La métrologie est faite par un dispositif du type du LNHB (Labo National Henry Becquerel) ou du LNE (Labo National d'Essai), dispositifs comparables, très coûteux et ayant le volume d'une baie électronique.

Au LNHB, le banc de mesure est dédié à la calibration précise des chambres d'ionisation (laboratoire « primaire », c'est-à-dire de référence), notamment pour les installations hospitalières. La partie électronique est constituée par un appareil Keithley pour mesure de très faible courant. Le circuit a une impédance d'entrée > à 10¹⁴ Ohms. (1 TéraOhm = 10¹² Ohms). La capacité d'intégration est constituée par un condensateur étalon extérieur à l'appareil. Le bruit de fond du système est de l'ordre du 1/10 de fA (1 fA pour l'invention avec un coût 100 fois plus faible).

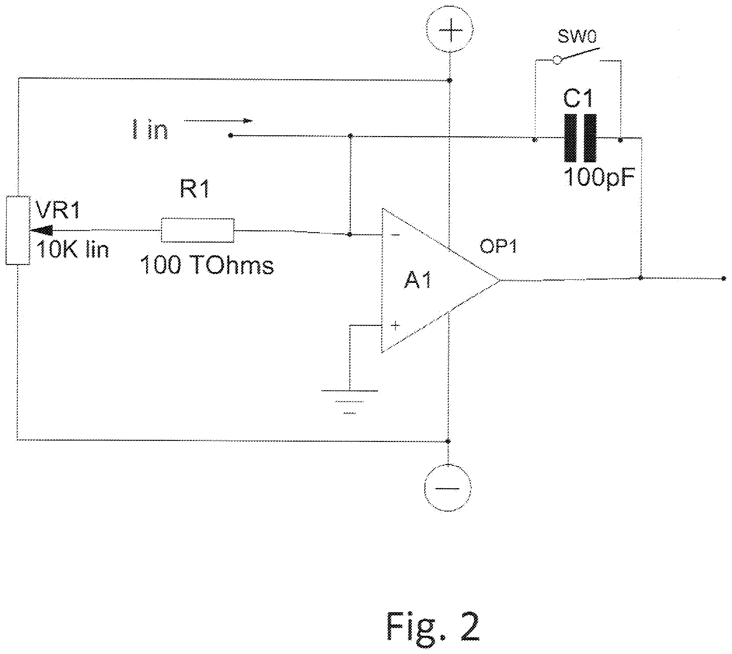

Conformément à la figure 2, le condensateur C1 constituant la capacité d'intégration est déchargé par un relais électromécanique SW0 en série avec une résistance de limitation de courant.

Au LNE, la partie électronique qui interface la chambre est réalisée par un circuit prototype élaboré à partir d'un amplificateur opérationnel de qualité métrologique, monté dans un circuit intégrateur très proche de celui du LNHB. L'amplificateur opérationnel a une impédance d'entrée > à 10¹⁴ Ohms. (1 Téraohms = 10¹² Ohms), qui est stable dans le temps. La capacité d'intégration est constituée par un condensateur étalon extérieur. Le bruit de fond du système est de l'ordre du 1/10 de fA (1 fA pour l'invention avec un coût 100 fois plus faible).

Dans ces deux cas, les condensateurs étalon utilisés sont coûteux. Par ailleurs, ils sont utilisés conjointement avec des résistances étalon elles-mêmes très coûteuses (par exemple une cinquantaine d'euros au lieu de quelques centimes d'euro), leur gestion est compliquée (stocks limités requérant des commandes planifiées à l'avance) et cette complexité et ces coûts sont voués à augmenter. Enfin, leur manipulation est délicate, impose l'usage de gants car le film lipoprotéique ainsi que les sels minéraux et l'humidité laissés par la peau humaine constituent une résistance de fuite non négligeable devant la valeur marquée.

La décharge du condensateur constituant la capacité d'intégration est faite par commutateur électromécanique qui court-circuite ce condensateur, le plus souvent via une résistance de limitation du courant. Ce commutateur doit avoir des performances élevées pour ne pas induire de microcoupures. Il requiert généralement des contacts dorés, de sorte que son coût est élevé et ne peut que croître. Dans le cas du LNE, le courant de commande du relais de court-circuitage est jugé trop perturbant, de sorte que la bobine de commande a été remplacée par un aimant permanent déplacé par un moteur pas à pas. Ces composants coûtent très cher, et ces coûts ne peuvent qu'augmenter rapidement à l'avenir.
Le choix de la valeur de la capacité d'intégration est lié à l'amplitude du courant à mesurer. Si le condensateur est petit, le montage sera plus sensible aux éventuelles fluctuations de la tension de polarisation de la chambre. En effet, la capacité parasite de la chambre, modélisable par une capacité en parallèle avec le générateur de courant, crée avec la capacité du condensateur d'intégration en série un pont capacitif qui divise les fluctuations de la tension de polarisation.

Si le condensateur est grand, sa stabilité dans le temps est plus grande à technologie égale, mais les temps de mesure sont plus longs.

Le LNE et le LNHB ont des objectifs différents. Ils choisissent la valeur de la capacité en conséquence.

Le LNE est dédié aux mesures de très faibles courants, par exemple pour des étalonnages d'ampèremètres ou de résistances étalon de très forte valeur (supérieures au TOhm). Il utilise donc une capacité d'intégration minimum de l'ordre de 0,1 à 1 pF. Compte tenu de cette très faible valeur, il doit prendre d'infinies précautions, et réalise en pratique un condensateur différentiel dont le diélectrique est un gaz sec, délimité par des anneaux de garde. L'ensemble étant relié au circuit par un câble blindé. Ce type de dispositif, visant à optimiser les performances presque à n'importe quel prix n'est évidemment pas envisageable dans un produit industriel.

Le LNHB est dédié à l'étalonnage des champs d'irradiation ou des chambres d'ionisation pour les hôpitaux. Compte tenu de l'existence de générateurs X par impulsions de certains dispositifs, il faut pouvoir recevoir les dizaines de pC ou les nC qui en résultent au niveau de la chambre d'ionisation, sans que le circuit d'intégration ne sature. De ce fait, il doit utiliser une capacité plus grande. Il utilise en pratique des capacités d'au moins 300 pF.

Les détecteurs portables de type Babyline™ utilisés en intégrateurs utilisent une capacité d'intégration de quelques nF. En effet, ils doivent pouvoir couvrir une très large gamme de débit de dose sans saturation et sans commutation sur une autre capacité. En outre, sa décharge est mécanique, faite par un opérateur, ce qui ne permet pas une cadence élevée de remise à zéro.

Ces dispositifs ont un circuit d'entrée à amplificateur opérationnel, dont l'offset est ajusté par un diviseur de tension entre les tensions d'alimentation, conformément à la figure 2.

### Mesure en radiologie portable.

Un appareil très connu et apprécié des professionnels est la Babyline ™. Cet appareil comporte une chambre d'ionisation d'un volume de l'ordre d'un demi litre (500 cm³) alimenté par une tension de polarisation de l'ordre de 300 V, et deux circuits de mesure de courant commutables manuellement : soit une mesure de courant par intégration soit une mesure par amplification monté en transimpédance, mais qui nécessite une résistance étalon de très forte valeur (supérieure au TOhm) très coûteuse et difficile à manipuler.

La Babyline ™ en intégrateur fonctionne comme le dispositif du LNHB ou du LNE, à ceci près que le dispositif mécanique de décharge est un commutateur manuel rotatif. Les impédances d'entrée sont comparables, avec la difficulté liée à l'implantation de composants ultrasensibles aux charges électrostatiques imposant des bracelets reliés à la terre et à l'établi. L'amplificateur opérationnel n'étant pas à l'époque de la conception un composant intégré, l'amplification se fait par des composants discrets, jadis FET et désormais Mosfet. En outre, certains de ces composants sont de plus en plus rares et de plus en plus coûteux.

Un commutateur aux contacts dorés permet de basculer en mesure directe sans intégration. L'amplificateur est alors monté en amplificateur de transimpédance, convertissant un courant en tension. Ce montage permet une mesure directe de la dose instantanée, alors que le dispositif traditionnel avec intégrateur nécessite une dérivation pour retrouver le signal instantané.

Cette Babyline ™ nécessite en outre, pour sa mesure de transimpédance, l'utilisation de résistances étalons de fortes valeur, coûteuses et fragiles, sensibles à la température. Elles exigent en outre de grandes précautions de manipulation.

Son circuit d'entrée, initialement à FET puis dans une version ultérieure à Mos-FET, comporte aussi un ajustement des courants de fuites par un diviseur de tension entre les tensions d'alimentation et une résistance de forte valeur.

D'autres dispositifs de moindres performances gardent le même schéma de principe, mais les composants sont moins coûteux et/ou moins soigneusement montés. Le commutateur électromécanique de décharge est parfois réalisé au moyen de commutateurs statiques, mais le rapport entre leur résistance à l'état passant et à l'état conducteur est beaucoup trop faible pour ne pas grever significativement la précision des mesures. En particulier, sa résistance en circuit ouverte n'atteint pas la valeur minimale de 100 TOhms. Et ils induisent des courants de fuite trop importants et pas assez constants pour être compensables.

Pour mesurer des courants de l'ordre de quelques fA, les impédances de certains composants doivent être très importantes (> 100 TOhms), un intégrateur comprend une capacité d'intégration qu'il faut régulièrement décharger à une valeur bien précise et qui peut varier en fonction de l'application. Un relais mécanique placé en parallèle peut remplir cette fonction, un interrupteur (switch) électronique a une impédance en circuit ouvert trop faible (au mieux de l'ordre du TOhm) et induit des courants de fuite trop importants.

Pour résumer, l'art antérieur se répartit en deux branches. La première branche évite la véritable mesure par intégration en choisissant de charger et décharger très vite un condensateur de faible valeur, la mesure ne se faisant alors plus directement par l'intégration analogique mais indirectement par le comptage des cycles de charge/décharge. Les performances sont moins élevées mais cela permet l'utilisation d'une électronique de commutation bien moins performante en termes de résistance entre l'état passant et l'état bloqué, et de la faire commuter plusieurs milliers de fois par seconde pour décharger le condensateur d'intégration.

Tous les autres circuits, plus soucieux de l'exactitude et de la représentativité de la mesure, partagent les mêmes inconvénients, même si ceux du LNE et du LNHB, beaucoup plus récents, se fondent sur des composants passifs de très hautes performances, des amplificateurs opérationnels de métrologie et des commutateurs également à hautes performances. Ces inconvénients découlent essentiellement de ce qu'une commutation intervient en parallèle avec le condensateur d'intégration (c'est-à-dire le condensateur dont la capacité constitue la capacité d'intégration) ou en série entre ce condensateur d'intégration et l'amplificateur opérationnel qui lui est associé au moment de la réinitialisation (c'est-à-dire de la remise de la charge du condensateur d'intégration dans son état de charge initial Q₀ d'avant la mesure). Pour ces dispositifs de l'art antérieurs, soit le circuit est coupé par un interrupteur en série entre le condensateur d'intégration et l'amplificateur opérationnel associé, soit un court-circuit est réalisé aux bornes de ce condensateur (éventuellement via une faible résistance limitant le courant à une valeur qui n'endommage pas ce composant). L'ensemble des connexions entre ce condensateur d'intégration (par métonymie cette capacité d'intégration) et l'amplificateur opérationnel change donc entre l'état d'intégration et l'état de réinitialisation.

Il en découle des performances limitées, dont on s'est efforcé de repousser les limites par l'utilisation de composants très performants, de plus en plus coûteux, et dont la mise en œuvre délicate exige une main d'oeuvre très qualifiée respectant des conditions contraignantes. On connait également des dispositifs de l'art antérieur tels que ceux décrits dans les demandes de brevet US2005/105310 et WO2010/109347.

### EXPOSE DE L'INVENTION

L'invention vise à rester dans le cadre d'une véritable mesure analogique par intégration, conformément à la seconde branche de l'art antérieur (Babyline, LNE, LNHB), ceci sans introduire de modification des connexions du condensateur d'intégration (par métonymie capacité d'intégration), ni sur lui-même (pas de court-circuit), ni à l'amplificateur opérationnel associé (pas d'interrupteur en série) entre l'état de mesure du circuit et son état de réinitialisation. Ceci en n'utilisant que des composants à bas coût et dont le coût est appelé à diminuer, alors que les électroniques de l'art antérieur utilisent des composants très coûteux et dont le coût est appelé à augmenter à l'avenir.

En d'autres termes, l'invention réalise l'intégration par un circuit dans lequel le condensateur d'intégration (par métonymie la capacité d'intégration) est connecté de la même manière dans l'état d'intégration et dans l'état de réinitialisation. Il n'existe aucun moyen permettant de court-circuiter ses électrodes pour la réinitialisation de l'intégrateur.

L'invention propose ainsi un dispositif pour la mesure d'un courant par intégration, ledit dispositif comportant :
- un premier amplificateur opérationnel OP1 comportant une première entrée inverseuse, le courant à mesurer étant appliqué sur ladite première entrée inverseuse ;
- un condensateur d'intégration disposé entre la première entrée inverseuse du premier amplificateur opérationnel OP1 et la sortie de ce premier amplificateur opérationnel ;
- un générateur de courant actif connecté à la première entrée inverseuse du premier amplificateur opérationnel OP1, ce générateur de courant étant configuré pour :
   - dans un premier état de mesure du dispositif, compenser les courants de fuite du dispositif ;
   - dans un second état de réinitialisation du dispositif, déclenché par une valeur de charge du condensateur d'intégration sensiblement égale à une valeur maximale Q_{Max} qu'elle peut avoir, générer un courant apte à remettre cette charge à sa valeur initiale Q₀ ;
- des moyens de commande configurés pour :
   - mémoriser un état initial de charge Q₀ correspondant à une tension V_{C0} en sortie du premier amplificateur opérationnel ;
   - placer le dispositif dans l'état de mesure et l'y maintenir jusqu'à ce que la charge du condensateur d'intégration atteigne sensiblement Q_{Max}, correspondant à une tension V_{CMax} en sortie du premier amplificateur opérationnel ;
   - lorsque la charge du condensateur d'intégration atteint sensiblement Q_{Max}, correspondant à une tension V_{CMax} en sortie du premier amplificateur opérationnel, placer le dispositif dans l'état de réinitialisation jusqu'à ce que la charge du condensateur d'intégration atteigne sensiblement Q₀.

La valeur initiale de charge Q₀ du condensateur d'intégration peut être choisie égale à zéro, mais aussi à toute valeur physiquement atteignable compte tenu de la tension d'alimentation du circuit.

La valeur maximale de charge QMax, que peut avoir le condensateur d'intégration est a priori la valeur maximale atteignable compte tenu de la tension d'alimentation du circuit. Toutefois l'opérateur peur choisir dans certaines circonstances de mesure de fixer lui-même une valeur de Q_{Max} comprise entre Q₀ et la valeur maximale atteignable compte tenu de la tension d'alimentation. Il convient donc de prévoir, compte tenu du signe du courant à mesurer, une plage de variations entre Q₀ et Q_{Max} dans le sens qui permet de passer de Q₀ et Q_{Max} sous l'effet du courant à mesurer, et dont l'écart Q_{Max} - Q₀ est adapté à l'intensité à mesurer.

La masse de référence des signaux correspond à un potentiel médian entre les tensions d'alimentation. Lorsque le circuit est alimenté par une seule alimentation, cette masse, elle est choisie à un potentiel médian que l'on crée par des résistances, ce potentiel de masse virtuelle peut néanmoins se situer n'importe où entre les tensions d'alimentation pourvu que le système reste dans un fonctionnement linéaire. Lorsque le circuit est alimenté par deux alimentations symétriques, cette masse correspond à leur point commun.

Par générateur de courant actif, on entend comportant des semiconducteurs aptes à fournir une puissance supérieure à la puissance du signal qui le traverse. Cette différence de puissance provient alors d'un circuit annexe apportant de l'énergie depuis une alimentation. A ce titre, le courant injecté dans un sens ou dans l'autre à l'entrée inverseuse du premier amplificateur opérationnel provient de l'alimentation de ce circuit actif, a priori la même que celle de l'ensemble du circuit selon l'invention. En conséquence, le point d'injection de ce courant a un potentiel flottant, c'est-à-dire qu'il suit celui que lui impose l'entrée inverseuse du premier amplificateur opérationnel. En pratique il ne bouge que de moins d'un mV dans les conditions normales d'utilisation.

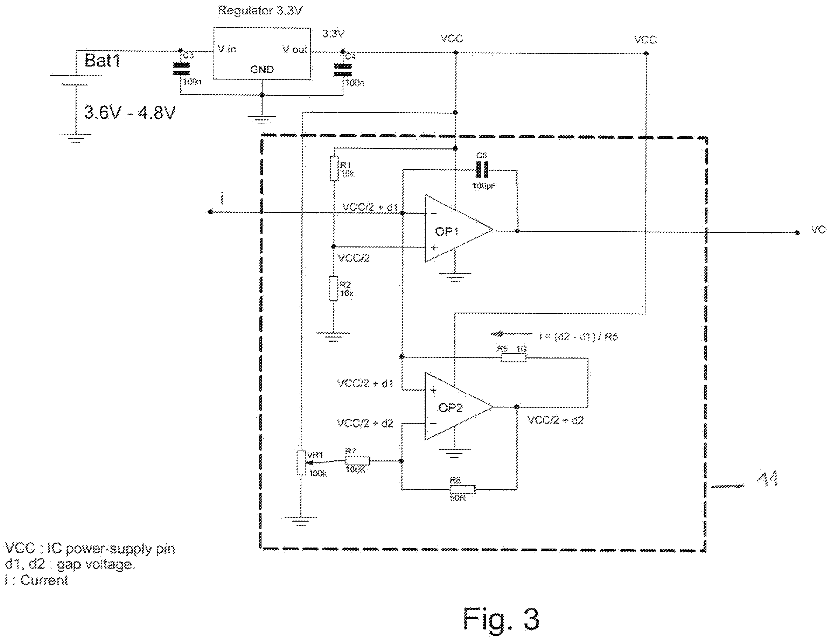

De manière plus particulière, ce générateur de courant comporte un deuxième amplificateur opérationnel OP2, monté en suiveur, tel qu'illustré à la figure 3. De préférence ces deux amplificateurs (OP1 et OP2) sont intégrés dans le même boitier, ainsi ils se trouvent à la même température. Une réalisation préférentielle de ce générateur de courant actif est constituée d'un amplificateur opérationnel OP2 monté en suiveur et comportant en outre une faible réaction positive, à l'aide d'une première résistance R5 de forte valeur (supérieure à 500 MOhms, et typiquement 1 GOhm). Cette figure 3 représente la version de base de l'invention, pour laquelle plusieurs perfectionnements avantageux vont être décrits.

Cette version de base fonctionne comme suit : le deuxième amplificateur opérationnel OP2 est monté en suiveur de la tension d'entrée inverseuse du premier amplificateur opérationnelOP1, avec une contre-réaction très forte (résistance très faible, ici nulle) entre la sortie du deuxième amplificateur opérationnel et l'entrée inverseuse du deuxième amplificateur opérationnel, de manière à avoir sensiblement un gain unité. La tension en sortie du deuxième amplificateur opérationnel est donc toujours égale à la tension d'entrée non inverseuse du deuxième amplificateur opérationnel, qui est la même que la tension d'entrée inverseuse du premier amplificateur opérationnel, aux imperfections physiques près des composants. En réalité, il existe un léger décalage de l'ordre de quelques centaines de µV au plus, qui est quasi-constant et suit toutes les variations de la tension d'entrée de l'entrée inverseuse du premier amplificateur opérationnel. C'est sur ce décalage que se fonde le générateur de courant.

La résistance R5 de forte valeur, supérieure à 500 MOhms généralement, ici égale à 1Gohms dans l'exemple de la figure 3, est reliée entre la sortie du deuxième amplificateur opérationnel OP2 et l'entrée non inverseuse du premier amplificateur opérationnel OP1. Comme elle a à ses bornes une ddp (différence de potentielle) quasi constante d2- d1 de quelques centaines de µV, elle est traversée par un courant i= (d2 - d1)/R5, c'est-à-dire en valeurs numériques 10⁻⁹ fois quelques 10⁻⁴V, c'est-à-dire quelques 10⁻¹³A. Ce courant, qui se trouve injecté à l'entré inverseuse du premier amplificateur opérationnel, est extrêmement stable, ce qui permet de le compenser en grande partie par un circuit d'offset décrit ultérieurement. Ce circuit, tel qu'illustré à la figure 3, constitué de OP2, de sa contre réaction et de sa réaction constitue donc bien un dispositif qui fonctionne en générateur de courant.

En outre, ce courant peut être ajusté via un offset appliqué sur l'entrée inverseuse du deuxième amplificateur opérationnel OP2. Cette variante est illustrée à la figure 3. Un premier offset, ajustable manuellement à la fabrication du circuit (réglage de sortie d'usine par un opérateur), est constitué d'un potentiel VR1 pris entre l'alimentation positive et la masse grâce à un potentiomètre VR1 (typiquement de 100 kOhms) dans le curseur duquel est connectée en série une résistance R7 qui aide à déterminer le gain appliqué par OP2 à cette tension d'offset. Ce gain doit être très faible compte tenu des grandeurs en jeu dans le générateur de courant. Pour ne pas modifier significativement le fonctionnement de ce générateur, R8 doit rester faible pour qu'OP2 ait un gain très proche de 1. Or ce gain, déterminé par le rapport R8/R7, doit être de l'ordre de quelques millièmes afin de ne pas induire un offset supérieur quelques fA sur l'entrée inverseuse de OP1. A titre d'exemple, avec un gain de 0.001, on obtient 1fA sur l'entrée inverseuse de OP1 pour 1 mV de VR1. Par ailleurs, en choisissant R7 entre 30 KOhms et 100 kOhms, et R8 à quelques dizaines d'Ohms, le gain de OP2 est de l'ordre de 0.001 (c'est-à-dire qu'il fonctionne en atténuateur inverseur).

Vu le rôle que jouent R8, R7 et VR1 dans le gain de OP2, R8, R7 et VR1 doivent être stables en température et précises à mieux que 5%. Ces contraintes respectée, le réglage manuel du potentiomètre VR1 permet de décaler le point de fonctionnement de OP2, et par là de compenser approximativement les courants de fuite du circuit à l'entrée inverseuse du premier amplificateur opérationnel. Cela se vérifie en mesurant la tension de sortie Vc du premier amplificateur opérationnel et la dérive qu'elle présente avant toute application d'un courant à mesurer. A titre indicatif, pour une capacité d'intégration de 100 pF, un courant de 10 fA produira une variation de Vc de 1mV/10 s ou 10mV pour 100 s. Un tel réglage opérateur n'est toutefois requis que juste après fabrication, en sortie d'usine, ou éventuellement après un choc ou une période exceptionnellement éprouvante pour le matériel.

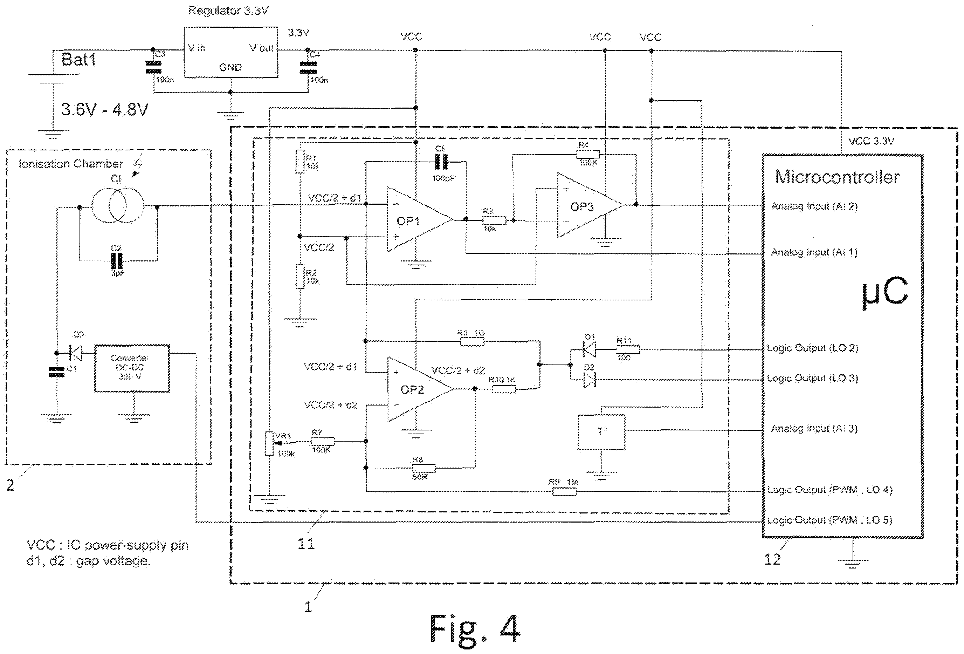

Le réglage d'offset par R7 et VR1 est ajusté pour compenser le plus possible les courants de fuite lorsque le circuit est dans l'état de mesure, et les ramener dans une fourchette de l'ordre de 1 à 10 fA. Lorsque le circuit de l'invention est doté d'un microcontrôleur pour piloter le basculement d'un état dans l'autre, ce microcontrôleur peut avantageusement délivrer sur une sortie logique LO4 des impulsions PWM dont la valeur moyenne est sommée avec l'offset de R7 et VR1, ajustant ainsi automatiquement le courant du générateur afin qu'il annule quasiment les courants de fuite sur l'entrée inverseuse de OP1 (fig.4).Comme les dispositifs précédents du LNE, LNHB Le ou même les appareils de type Babyline ou chambre à gaz, le dispositif selon l'invention présente deux états distincts. Le premier correspondant à l'intégration du courant à mesurer via la charge d'un condensateur d'intégration (C1 dans l'art antérieur de la Fig. 2, C5 dans l'invention de la Fig. 3 et suivantes), dont la capacité est dite capacité d'intégration. Ce premier état existe dans l'invention, et grâce au générateur de courant décrit ci-dessus permet une meilleure compensation des courants de fuite.

Le second état pour un amplificateur par intégration est la réinitialisation de la charge du condensateur d'intégration à sa valeur de départ Q0, puisque cette charge ne peut croître indéfiniment sous l'effet du courant à mesurer. Dans l'art antérieur, cette réinitialisation est une décharge brutale du condensateur d'intégration, par un court-circuit entre ses électrodes, ce court-circuit pouvant se faire à travers une résistance de faible valeur destinée à limiter la valeur de crête du courant. Selon l'invention, cet état de réinitialisation n'est plus un court-circuit du condensateur d'intégration mais une charge du condensateur d'intégration, en sens inverse de la charge résultant du courant à mesurer au moyen d'un courant de charge de sens contraire. Cela pourrait se faire laborieusement par une modification temporaire de l'offset du générateur de courant, par exemple en appliquant à l'entrée inverseuse de OP2 un offset de forte valeur et de signe approprié, par exemple au moyen d'un autre pont potentiométrique et d'un interrupteur, non représentés par un schéma car évidents pour l'homme de métier. Toutefois ce moyen simple serait peu performant et rendrait difficile le basculement d'un état dans l'autre. En outre, il est souhaitable que le courant de réinitialisation soit beaucoup plus fort et de sens opposé que le courant dû à la mesure. Ce courant annule l'effet cumulé des charges intégrées depuis la dernière réinitialisation, et replace la valeur de charge du condensateur d'intégration à sa valeur initiale Q₀. S'il est, par exemple, dix fois, cent fois, ou mille fois plus grand que le courant à mesurer, le retour de la capacité à sa valeur initiale se fera dix fois, cent fois, ou mille fois plus rapidement. Cette valeur est donc modifiable dans une très large plage sans pour autant sortir de l'invention : seules les conditions technologies des circuits et le temps d'intégration voulu limitent cette valeur. Il faut seulement veiller à ne pas demander un courant si intense qu'il nuise par ailleurs à la stabilité du circuit, ce qui est trivial pour l'homme du métier.

Préférentiellement, ce basculement d'un état à l'autre se fait grâce à un perfectionnement constitué de deux diodes D1 et D2 et d'une résistance R10 de faible valeur (typiquement 1 kOhm). Les figures 4 et 5 montrent leur implantation dans le circuit dans le cas où elles sont actionnées par un microcontrôleur, ce qui est très avantageux. Toutefois on peut également réaliser l'invention en remplaçant les sorties de microcontrôleur notées LO3 et LO4 par des tensions logiques appliquées manuellement aux diodes D1 et D2 par action manuelle sur des interrupteurs ou par des circuits logiques. Cette réalisation simplifiée étant évidente pour l'homme de métier, elle n'a pas été représentée graphiquement. Les diodes D1 et D2 représentées en figures 4 et 5, connectées en sens inverse à partir d'un point commun à la sortie de OP2 (dont le potentiel est très proche de Vcc/2), en aval d'une résistance R10 de faible valeur (typiquement 1 kOhm) et dont l'autre extrémité est connectée :
- pour D1, connecté au point commun des diodes D1 et D2 et à R10 par sa cathode, l'anode est reliée via une résistance de protection de faible valeur R11 à un niveau logique bas lorsque le circuit est dans son état de mesure, et un niveau logique haut lorsque le circuit est dans son état de réinitialisation et qu'on veut injecter dans C5 un courant dans un premier sens
- pour D2, connecté au point commun des diodes D1 et D2 et à R10 par son anode, la cathode est reliée à un niveau logique haut lorsque le circuit est dans son état de mesure, et un niveau logique bas lorsque le circuit est dans son état de réinitialisation et qu'on veut injecter dans C5 un courant dans un second sens.

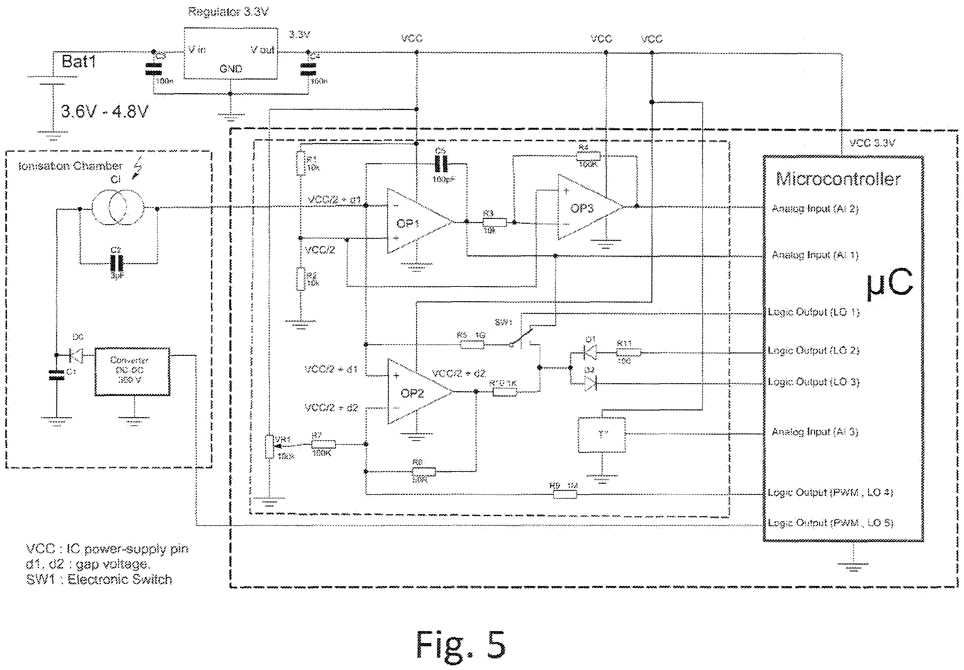

Ces niveaux logiques peuvent être appliqués manuellement par des interrupteurs, ou encore par des circuits logiques, selon une disposition évidente pour l'homme du métier et qui n'a donc pas besoin d'être illustrée. Toutefois ils sont très avantageusement appliqués par un microcontrôleur si le circuit selon l'invention en possède un. Cette configuration est représentée sur les figures 4 et 5. Dans ce cas :
- D1 a son anode reliée via R11 (de l'ordre d'une centaine d'ohms) à une sortie logique LO2 du microcontrôleur, portée au niveau logique bas lorsque le circuit est dans son état de mesure, et au niveau logique haut lorsque le circuit est dans son état de réinitialisation et qu'on veut injecter dans C5 un courant dans un premier sens ;
- D2 a sa cathode reliée à une sortie logique du microcontrôleur LO3 se trouvant au niveau logique haut lorsque le circuit est dans son état de mesure, et au niveau logique bas lorsque le circuit est dans son état de réinitialisation et qu'on veut injecter dans C5 un courant dans un second sens.

C'est alors le microcontrôleur qui déclenche les changements d'un état à l'autre selon l'état de charge du condensateur d'intégration. Cet état lui est connu puisqu'il commande directement la tension Vc de sortie de l'amplificateur opérationnel OP1 monté en intégrateur, et rentre sur sa première entrée analogique Al1.

Lorsque le circuit est dans l'état de mesure par intégration, les deux diodes D1 et D2 sont polarisées en inverse par la commande du microcontrôleur. Ces diodes ont un courant inverse de l'ordre de quelques pA, mais ces courants ne sont pas rigoureusement identiques et un courant résultant de la différence est collecté par la sortie de l'OP2 via la résistance R10. Ce courant traversant la résistance R10 crée une tension qui vient s'ajouter ou se retrancher par rapport à la sortie de l'OP2. Il en résulte une modification de la tension de sortie de OP2 de quelques nano Volts, dont l'effet sur le générateur de courant est négligeable.

Dans le second état du circuit, dit de réinitialisation, le microcontrôleur force la charge ou la décharge rapide de la capacité d'intégration, selon qu'il actionne l'une ou l'autre de ses sorties logiques :
- si la diode D1 conduit, la résistance R5 (1 GOhm) est portée à un potentiel égale à la tension d'alimentation moins la chute de tension dans D1, soit VCC - 0.6V, et charge la capacité d'intégration avec un courant de l'ordre d'1 nA ;
- si c'est la diode D2 qui conduit, la résistance R5 (1 GOhm) est portée à un potentiel de 0.6V et décharge la capacité avec un courant de 1 nA. Pour une capacité de 100 pF, la tension pourra évoluer à raison de 1 V pour 100 ms. Ce système ne fait appel à aucun système de contacteur mécanique ou électronique.

Dans ce second état les diodes D1 et D2 ne sont jamais simultanément passantes. Toutefois elles pourraient l'être accidentellement par suite d'une erreur de programmation ou d'un défaut du microcontrôleur. Pour limiter le courant qui pourrait alors circuler, on intercale la résistance R11, d'une centaine d'ohms, afin de limiter le courant entre les sorties logiques du microcontrôleur.

Toutefois l'invention présente une autre caractéristique avantageuse tout à fait incompatible avec les dispositifs de l'art antérieur. Il permet de ne plus se limiter à un état de départ où la charge Q du condensateur d'intégration serait nulle. En effet, selon l'invention le condensateur peut avoir en début de mesure d'intégration une charge Q₀, qui peut être par exemple une charge de signe opposé à la charge que peut susciter le courant à mesurer à la fin de l'état d'intégration. Au maximum des possibilités techniques du circuit, on peut fixer sa valeur à celle de la charge maximale atteignable Q=CV_{Max}, où V_{Max} est la tension maximale à laquelle le condensateur d'intégration peut être chargé, mais avec un signe opposé au signe de l'évolution de la charge sous l'effet du courant à mesurer. Ainsi, si le courant à mesurer fait décroître la charge, on peut précharger initialement le condensateur d'intégration à une valeur positive égale à CV_{Max}. Ceci permet au dispositif selon l'invention une étendue de mesure double de celle des dispositifs de l'art antérieur.

Pour résumer ce second état selon l'invention, on peut le caractériser par l'absence de modification des connexions du condensateur d'intégration sur lui-même et à l'amplificateur opérationnel associé entre les deux états dans lesquels il peut se trouver. Mais on peut aussi le caractériser par la capacité du générateur de courant à générer un courant apte à remettre la première capacité d'intégration dans un état initial de charge Q₀ lorsque la charge effective de ce condensateur atteint une valeur maximale Q_{Max}. En d'autres termes, dans cet état de réinitialisation, le générateur de courant de l'invention est apte à injecter dans le condensateur d'intégration un courant au moins K fois supérieur au courant à mesurer, et de sens adéquat pour remettre au moins K fois plus rapidement le condensateur d'intégration dans l'état de charge Q₀, ce qui constitue une réinitialisation du dispositif. La valeur K est au moins égale à 10, mais plus généralement de l'ordre de 100, de 1000 ou plus encore, selon les mesures à effectuer. L'invention comporte donc un générateur de courant apte à placer la capacité d'intégration C5 dans toutes les valeurs de charge possibles Q₀, que ce soit au départ ou dans chaque état de réinitialisation. Cette remise de la charge du condensateur d'intégration à Q₀ constitue une réinitialisation du dispositif qui permet un nouveau basculement dans le premier état ci-dessus dit état de mesure.

On a qualifié la valeur maximale de tension de sortie de OP1 en fin d'étendue de mesure par sa valeur absolue. En effet, l'invention permet de partir d'un état de charge Q₀ quelconque, la fin d'étendue de mesure étant alors la valeur maximale de charge Q_{Max} que peut atteindre le condensateur d'intégration compte tenu des tensions d'alimentation du circuit. Si l'on connait le sens dans lequel le courant à mesurer va modifier cette charge, l'invention permet de choisir de placer la charge Q₀ à la valeur maximale possible dans le sens inverse, de manière à avoir la plus grande plage de variations possible entre Q₀ et Q_{Max}.

La tension analogique sortant du premier amplificateur opérationnel représente l'intégrale du courant à mesurer par le dispositif. La valeur de seuil haut Vₘₐₓ est paramétrable et mémorisable par le microcontrôleur par exemple. Le microcontrôleur fait basculer le dispositif dans l'état de mesure ou dans l'état de réinitialisation par l'envoi d'un signal logique (numérique).

La figure 4 représente schématiquement un mode de réalisation préférentiel où ce basculement est commandé par le microcontrôleur grâce à une première diode D1 et une deuxième diode D2 polarisées en inverse, et la résistance R10 placée entre le point commun de ces diodes et la sortie du deuxième amplificateur opérationnel OP2. L'anode de la première diode D1 est reliée à une première sortie logique du microcontrôleur, et la cathode de la deuxième diode D2 est reliée à une seconde sortie du microcontrôleur, les dites première et deuxième sorties du microcontrôleur permettent alors le contrôle du basculement du dispositif entre l'état d'initialisation et l'état de mesure. Ce basculement fonctionne comme suit. Dans l'état d'intégration du circuit, les deux diodes D1 et D2 sont polarisées en inverse. Elles ont alors chacune un courant inverse de l'ordre de quelques pA, mais qui ne sont pas tout à fait égal d'une diode à l'autre. La différence entre les deux courants inverses est un courant résultant qui s'ajoute algébriquement au courant de sortie de OP2, via la résistance R10. Elle est choisie d'une valeur suffisamment faible pour que la ddp ainsi générée aux bornes de R10 ne perturbe pas significativement le fonctionnement du générateur de courant. Typiquement, R10 est de l'ordre de 1Kohm, ce qui génère aux bornes de R10 quelques nano Volts. Toutefois, si l'on choisit des diodes dont le courant de fuite en inverse est supérieur à 1 pA, la différence des courants peut s'avérer légèrement sensible à la température.

Dans l'état de mesure du circuit selon l'invention, la sortie logique LO2 du microcontrôleur associée à D1 est à l'état bas et la sortie logique LO3 associée à D2 est à l'état haut. Dans l'état de réinitialisation, si le microcontrôleur place au niveau haut sa sortie logique LO2 (reliée à l'anode de D1 via une résistance série de protection), alors D1 conduit et la résistance R5 (typiquement de 1Gohm) est portée à un potentiel de VCC - 0.6V, ce qui charge la capacité d'intégration C5 avec un courant de 1 nA.

Dans l'état de réinitialisation, si au contraire le microcontrôleur place au niveau bas sa sortie logique LO3, la diode D2 conduit. L'extrémité de la résistance R5 reliée à D2 est alors portée à un potentiel de 0.6V, ce qui occasionne en elle un courant de 1nA qui décharge la capacité d'intégration C5 avec un courant de 1 nA.

Cette valeur d'un nA convient bien pour une capacité C5 de 100 pF, auquel cas la tension à ses bornes pourra évoluer à raison de 1 V pour 100 ms. Il est aisé de l'adapter à une autre valeur de C5 ou à un courant différent de charge/décharge.

Ce montage à deux diodes et une résistance R10 ne fait appel à aucun système de contacteur mécanique ou électronique. Par sécurité, on place en série avec D1 une résistance R11 de l'ordre de 100 ohms qui limite le courant entre les sorties du µcontrôleur dans le cas où les deux diodes seraient malencontreusement polarisées en direct (par exemple en cas d'erreur de programmation du µcontrôleur). Avec ce perfectionnement, le microcontrôleur commande le basculement dans l'état de mesure ou l'état de réinitialisation du dispositif au moyen de deux sorties logiques distinctes.

Selon un autre perfectionnement, applicable aux montages destinés à recevoir le courant d'une chambre d'ionisation, et cumulable avec les précédents perfectionnements, le microcontrôleur est apte à piloter la tension de polarisation de la chambre grâce à des impulsions modulées en largeur (PWM pour Pulse Width Modulation) générées par une quatrième sortie logique (LO 5). Ces impulsions sont configurées pour générer une tension moyenne apte à piloter le générateur de tension de polarisation. Ce générateur peut par exemple être réalisé à l'aide d'un convertisseur DC-DC selon la technique connue d'un étage à transformateur élévateur et du pompage par diodes et capacités.

Selon un autre perfectionnement cumulable avec les précédents qui comportent un microcontrôleur, ce microcontrôleur est apte à maintenir à quasiment zéro les courants de fuite en l'absence d'un signal de courant à mesurer à l'aide d'une troisième sortie logique (LO 4), fonctionnant comme la quatrième sortie logique (LO 5) en PWM. Atténuées par une résistance R9 de l'ordre d'un MOhm, elle apporte à l'entrée inverseuse du deuxième amplificateur opérationnel OP2 un offset qui s'ajoute à celui apporté par le potentiomètre VR1 et la résistance R7. Cet offset est suffisant pour maintenir à une valeur très faible (typiquement de l'ordre de 10fA) les courants de fuite à l'entrée inverseuse du premier amplificateur opérationnel OP1.

De manière préférentielle, le dispositif comporte aussi un moyen de mesure des dérives thermiques dudit dispositif, ledit moyen de mesure des dérives thermiques étant relié à une entrée du microcontrôleur. Le moyen de mesure des dérives thermiques est par exemple un capteur de température disposé au voisinage ou contre le boitier comportant le premier amplificateur opérationnel, et le signal de sortie du moyen de mesure des dérives thermiques est appliqué à une entrée du microcontrôleur afin que ce dernier puisse compenser la dérive thermique en agissant sur le générateur de courant par les moyens évoqués ci-dessus. Si les amplificateurs OP1 et OP2 sont dans le même boîtier, la mesure de température s'en trouve améliorée.

Selon une variante, le circuit selon l'invention peut aussi fonctionner selon un troisième état dit en amplificateur de transimpédance résistif (illustré à la figure 5). Le passage dans ce troisième état est commandable par un inverseur unipolaire SW1, de préférence électronique. Son contact central est relié à l'extrémité de R5 non reliée à l'entrée non inverseuse de OP2, et permet de connecter cette électrode soit sur le point commun entre D1 et D2 pour obtenir un fonctionnement du circuit en mesureur de courant par intégration, soit sur la sortie de OP1 pour obtenir un fonctionnement du circuit en amplificateur de transimpédance. Lorsque cet interrupteur SW1 est électronique, il est préférentiellement commandable par le microcontrôleur.

En effet, dans le cas de la connexion du contact central avec la sortie de OP1, la résistance R5 se trouve en parallèle avec le condensateur d'intégration C5, dont l'influence est faible aux cadences de travail du circuit. C5 sert alors à lisser les signaux parasites de plus haute fréquence. Ceci correspond au troisième état optionnel du circuit, dans lequel OP1 ne fonctionne plus en intégrateur mais en amplificateur de transimpédance résistif, avec pour résistance de contre-réaction R5. Le basculement dans ce troisième état peut être réalisé manuellement par un opérateur. Toutefois, si le circuit comporte un microcontrôleur, il peut avantageusement être commandé par une interrupteur électromécanique ou à semiconducteur actionné par ce microcontrôleur.

Lorsque le circuit selon l'invention possède un microcontrôleur, ce dernier est avantageusement muni de deux convertisseurs analogiques/numériques, ce qui permet d'avoir, outre la première voie de mesure correspondant à la sortie de OP1 entrant sur une première entrée analogique, une seconde voie de meure plus sensible correspondant à cette même sortie de OP1 qui a été amplifiée, par exemple d'un facteur 10, par un troisième amplificateur opérationnel OP3 dont la sortie entre sur cette seconde entrée analogique du microcontrôleur.

L'invention concerne également un système pour la mesure d'un courant par intégration, ledit système comportant une chambre d'ionisation dans laquelle circule le courant et un dispositif pour la mesure du courant par intégration selon l'un des modes de réalisation précédemment décrits.

### BRÈVE DESCRIPTION DES FIGURES

D'autres caractéristiques et avantages de l'invention ressortiront à la lecture de la description qui suit, en référence aux figures annexées qui illustrent :
- la figure 1, une vue schématique de l'électronique d'une chambre d'ionisation type CIEP 42 constituant le premier art antérieur cité ;
- la figure 2, une vue schématique du circuit d'ajustement des courants de fuite selon les autres arts antérieurs cités (métrologie et Babyline) ;
- la figure 3 représente schématiquement le générateur de courant 11, placé dans la réalisation de base de l'invention ;
- la figure 4 représente la réalisation préférentielle d'un dispositif de mesure de courant à intégration selon l'invention doté de la commutation d'états par le circuit à diodes D1 et D2 et reliée à une chambre d'ionisation ;
- la figure 5 représente la réalisation d'un dispositif de mesure de courant fonctionnant soit par intégration, soit en amplificateur de transimpédance résistif, et reliée à une chambre d'ionisation.

Pour plus de clarté, les éléments identiques ou similaires sont repérés par des signes de référence identiques sur l'ensemble des figures, hormis la 1 qui traite de l'art antérieur.

### DESCRIPTION DÉTAILLÉE D'UN MODE DE RÉALISATION

La figure 1 représente le schéma électronique de l'antériorité qui charge et décharge très fréquemment le condensateur d'intégration, et émet à la fin de chaque cycle de charge une impulsion allant par la sortie 10 vers une électronique de comptage. Ce n'est que le nombre de ces impulsions qui donne une évaluation du courant à mesurer. Les portes logiques U1B et U1C donnent une impulsion de polarisation qui coopère avec la diode D1 (PAD 1).

La figure 2 représente un schéma de principe de l'art antérieur qui effectue comme l'invention une véritable mesure en continu du courant d'entrée. L'ensemble formé par le potentiomètre VR1 et la résistance R1 constitue une polarisation qui vise à compenser les courants de fuite. Le condensateur d'intégration C1 est, lorsqu'il est chargé au maximum, réinitialisé par un court-circuit entre ses électrodes par l'interrupteur SW0, qui est nécessairement un contact mécanique actionné par un électroaimant pour les applications les plus précises. En effet, un interrupteur statique possède à l'état ouvert un courant de fuite non négligeable devant le courant à mesurer.

La figure 3 représente la réalisation la plus basique de l'invention. On n'y a pas mentionné de système de mémorisation de l'état initial de charge Q₀ correspondant à une tension V_{C0} en sortie du premier amplificateur opérationnel, puisque dans ce cas la mémorisation est faite par l'intervention d'un opérateur. Idem pour l'offset supplémentaire à appliquer à l'entrée inverseuse de OP2, au moyen d'un interrupteur manuel ou à semi-conducteur relié à une tension de polarisation adéquate pour que le générateur de courant produise le courant apte par son signe et son amplitude à remettre la charge du condensateur à la valeur initial Q₀. Cette configuration impose une surveillance de la valeur de la charge de C5 soit par l'opérateur soit par un circuit annexe banal à réaliser par l'homme du métier. Aux figures 4 et 5, le circuit de l'invention proprement dite 11 (encadré central) est associé à une chambre d'ionisation à titre d'exemple non limitatif. L'encadré 2 représente schématiquement une chambre d'ionisation Cl, et de son alimentation de polarisation en tension. On a schématisé la capacité parasite de Cl par C2. Le dispositif de mesure de courant de l'encadré central 11 est également relié à un élément d'accumulateur Bat1 au lithium de 3,6V nominal (ou à quatre éléments accumulateurs NiMH de 4,8V au total). Enfin il est aussi relié à une alimentation régulée Regulator (selon le mot anglais) de 3,3V pour l'alimentation des composants actifs du dispositif de mesure.

Le courant à mesurer sort de la chambre d'ionisation Cl et est envoyé dans le dispositif pour sa mesure. Le dispositif de mesure 1 comporte une partie circuit électronique 11 et une partie moyens de commande. Si dans la version la plus basique cela peut être effectué par un opérateur, une version un peu plus élaborée peut utiliser des circuits logiques de base pour assurer ces fonctions. Toutefois, les schémas 4 et 5 les représentent ici constitués par un microcontrôleur 12.

Dans les figures 4 et 5, le circuit électronique 11 comporte un premier amplificateur opérationnel OP1. Le premier amplificateur opérationnel OP1 est alimenté par une source de tension continue, ici délivrant une tension stabilisée Vcc=3.3V. Le courant à mesurer est envoyé sur l'entrée inverseuse du premier amplificateur opérationnel OP1. Du fait du pont diviseur de tension constitué par les résistances R1 et R2 de 10kohms chacune, l'entrée inverseuse et l'entrée non inverseuse du premier amplificateur opérationnel OP1 sont au potentiel Vcc/2 pour l'entrée non inverseuse et Vcc/2+d1, d1 représentant la tension différentielle d'entrée du premier amplificateur opérationnel.

Une première capacité C5 est montée en contre-réaction sur le premier amplificateur opérationnel OP1, i.e. entre l'entrée inverseuse et la sortie du premier amplificateur opérationnel OP1. Comme expliqué précédemment, cet étage du circuit constitue un intégrateur. La tension aux bornes de la capacité d'intégration C5 représente l'intégrale du courant à mesurer, et détermine la tension de sortie Vc de l'amplificateur opérationnel OP1. En dérivant cette tension, on pourra retrouver la valeur moyenne du courant dans les cas où cette valeur est trop faible pour une mesure directe, comme c'est le cas pour la sortie d'une chambre d'ionisation.

Le circuit 11 comporte également un troisième amplificateur opérationnel OP3 monté en sortie du premier amplificateur opérationnel OP1 en montage amplificateur inverseur avec un gain adapté selon la plage de fonctionnement voulue pour la première capacité dite d'intégration C5. Entre la sortie de OP1 et l'entrée inverseuse de OP3, se trouve une troisième résistance R3 de 10kOhms et entre la troisième résistance R3 et la sortie du troisième amplificateur opérationnel OP3, se trouve une quatrième résistance R4 de 100kOhms. Ainsi la tension en sortie du troisième amplificateur opérationnel OP3 est égale à dix fois la tension en sortie du premier amplificateur opérationnel OP1, cela permet d'obtenir un effet zoom lorsque le courant à mesurer est très faible. En effet, pour éviter les risques de saturation des circuits, on cherche à avoir une plage de tension de fonctionnement de la première capacité allant de 0.1 à 0.9 fois la tension d'alimentation du circuit. Si les courants à mesurer sont très faibles (quelques fA), l'évolution de la tension sur la capacité d'intégration C5 est lente, soit par construction on pourra diminuer la valeur de la première capacité, soit on utilisera la sortie du troisième amplificateur OP3, du fait de son caractère amplificateur de tension, l'évolution de la tension est multipliée par 10 ce qui permet de diviser par 10 le temps d'intégration .ceci permet de ramener le temps de mesure du courant provenant de la chambre d'ionisation à une valeur confortable pour l'opérateur, i.e. pour un mesureur portable : un temps ne dépassant guère une minute pour les plus bas niveaux.

Il n'est pas forcément nécessaire de passer par une valeur amplifiée de la tension de sortie du premier amplificateur opérationnel OP1 pour effectuer la mesure de courant. En effet, pour une chambre d'ionisation ayant un rayonnement de 0.1 Gy/h, un mesureur portable de type Babyline donne une variation de signal de sortie non amplifié (en sortie de OP1) de 5V/s. Dans ce cas, il n'est pas nécessaire d'amplifier la tension de sortie de OP1, on peut effectuer directement la mesure (en l'envoyant sur une entrée analogique du microcontrôleur µC). En outre, dans ce cas, la tension en sortie du troisième amplificateur opérationnel OP3 est à saturation et donc non prise en compte par le microcontrôleur µC. Le microcontrôleur comporte une première entrée analogique Al1 reliée à la sortie du premier amplificateur opérationnel OP1 afin de recevoir la première tension analogique Vc du premier amplificateur opérationnel OP1. Le microcontrôleur comporte également une deuxième entrée analogique Al2 reliée à la sortie du troisième amplificateur opérationnel OP3 afin de pouvoir travailler également lorsque le courant à mesurer est très faible (cf. explication ci-dessus pour l'effet zoom pratiqué par le troisième amplificateur opérationnel OP3).

Le circuit électronique 11 comporte également un générateur de courant pilotable par le microcontrôleur constitué, dans cet exemple de réalisation, par un deuxième amplificateur opérationnel OP2. L'OP2 rempli quatre fonctions simultanées : 1) Suiveur non inverseur 2) générateur de courant (R5) 3) Sommateur atténuateur inverseur (VR1, R7, R8, R9) 4) Elimine l'influence des courants de fuite des diodes D1 et D2 (R10). La première fonction de OP2 est de suivre la tension au borne de l'entrée inverseuse de OP1, l'entrée + de OP2 est reliée à l'entrée inverseuse de OP1 et la sortie de OP2 est reliée à son entrée inverseuse par une résistance de 50 Ohms. La deuxième fonction de OP2 est de générer un courant constant dans l'entrée inverseuse de OP1, la tension entre l'entrée + et la sortie de OP2 est légèrement différente (< 1mV) . Via la résistance R5, un courant de plusieurs dizaines de fA sera injecter dans l'entrée de OP1.pour faire varier le courant, la tension en sortie de OP2 sera décalée par le sommateur atténuateur inverseur constitué par VR1,R7, R8 , pour 1 mV de variation sur VR1 il y a 1 µV en sortie de OP2 qui produira une variation de courant de 1 fA sur l'entrée inverseuse de OP1 via R5. Ce réglage est manuel et sera réalisé en sortie de fabrication ou lors d'un étalonnage du dispositif. Ce réglage permet de ramener le courant entrant sur l'entrée inverseuse de OP1 à une dizaine de fA. De plus, une sortie logique du microcontrôleur modulée en largeur d'impulsion (PWM en anglais ou MLI en français) sera connectée à la résistance R9, cette modulation venant s'ajouter à l'entrée du sommateur, modifiera également le courant généré et injecté sur OP1, cette fonction est nécessaire pour corriger d'éventuelles variations du courant de fuite notamment dû aux effets de température .La dernière fonction de OP2 est dans le mode intégration , (mesure) de pomper ,via R9, le courant différentiel inverse des diodes D1 et D2.Ce courant traversant R10 n'aura pas d'influence significative sur le courant du générateur. Reste la fonction de charge ou décharge de la capacité d'intégration (C5), cette fonction est assurée par deux sorties logiques du microcontrôleur, par les deux diodes D1 et D2 et par R10.

Dans l'état de mesure (intégration) du circuit, les diodes D1 et D2 sont polarisées en inverse. Elles ont chacune un courant inverse de l'ordre de quelques pico ampères, de préférence inférieur au pA. L'anode de la première diode D1 est reliée à une première sortie logique LO2 du microcontrôleur et la deuxième cathode de la deuxième diode D2 est reliée à une seconde sortie logique LO3 du microcontrôleur. Dans l'état de réinitialisation, l'une au l'autre de ces deux sortie logiques bascule pour charge la capacité d'intégration dans un sens ou dans l'autre, afin de ramener sa charge à la valeur initiale Q₀.. C'est par ce basculement de l'une ou l'autre de ces sortie logiques que le microcontrôleur peut faire sortir le circuit de l'état de mesure et le faire bascule dans l'état de réinitialisation, et commander le sens de la réinitialisation selon que c'est l'état de LO2 ou de LO3 qui est basculé. Les courants traversant les première et deuxième diodes ne sont pas absolument identiques, ainsi un courant résultant de leur différence revient par la résistance R10 vers OP2 ; ce courant produit une tension de quelques nV qui a une influence négligeable sur le générateur de courant. Lorsque la première diode D1 conduit et la deuxième diode D2 ne conduit pas, la résistance R5, dite de contre réaction, est portée à un potentiel de Vcc-0.6V et charge ainsi la première capacité C5 avec un courant de 1nA. Si la deuxième diode D2 conduit, et la première diode D1 ne conduit pas, la résistance de contre-réaction R5 est portée à un potentiel de 0.6V et décharge la première capacité C5 avec un courant de 1nA. Ainsi le dispositif de mesure de courant n'utilise aucun contacteur mécanique pour la réinitialisation du courant circuit. Une onzième résistance R11 est disposée entre la deuxième sortie LO2 du microcontrôleur et la première diode D1 pour limiter le courant entre les deuxième et troisième sorties du microcontrôleur si les diodes étaient polarisées en directes, en cas d'erreur de programmation du microcontrôleur.

Le dispositif peut également comporter, tel qu'illustré à la figure 5, un premier interrupteur électronique SW1 disposé entre la sortie du deuxième amplificateur opérationnel OP2 et la cinquième résistance R5. Cet interrupteur permet de basculer le contact central relié à l'extrémité de R5 soit vers la sortie du deuxième amplificateur opérationnel OP2 pour le fonctionnement du dispositif en mesure par intégration telle que précédemment décrite ; soit de basculer vers C5 et la sortie du premier amplificateur opérationnel OP1. Dans ce cas la cinquième résistance R5 se trouve en parallèle avec la capacité d'intégration C5 et son effet prédomine aux fréquences basses utilisées pour les mesures. L'effet de C5 se limite à un léger lissage d'éventuelles fluctuations parasites. Ainsi dans ce dernier cas, on dispose d'un amplificateur de transimpédance dont la première capacité joue le rôle de filtrage des parasites éventuels. L'interrupteur SW1 est préférentiellement commandé par le microcontrôleur au moyen d'une première sortie logique LO1.

A la première mise sous tension du dispositif, des courants de fuite apparaissent puisqu'ils sont imparfaitement compensés. Mais ils sont stables dans le temps, ce qui permet à un opérateur en usine de les compenser en grande partie par action sur VR1 qui constitue un offset du circuit générateur de courant autour de OP2, comme vu précédemment. Cela permet de faire varier de quelques microvolts la tension en sortie du deuxième amplificateur opérationnel OP2 et ainsi ramener les courants de fuite à une vingtaine de femto ampères voire quelques fA. Toutefois lorsque le montage comporte un microcontrôleur, on lui laisse une marge de manœuvre d'environ + ou - 80fA et on préfère laisser le PWM à un rapport cyclique de l'ordre de 50%, et l'action autorégulatrice du générateur de courant va réduire cette valeur à quelques fA. Ceci pour un circuit réalisé avec des composant standards, hormis les quelques spécifications plus précises faites ci-dessus. Il est évident qu'avec des amplificateurs opérationnels de mesure, cette valeur serait réduite. Il en est de même si l'on utilise des composants passifs plus précis et plus stable que ce qui a été mentionné ci-dessus comme condition minimale.

Le microcontrôleur comporte également une troisième sortie logique (LO 4) apte à délivrer des impulsions modulées en largeur (PWM) reliée à l'entrée inverseuse du deuxième amplificateur opérationnel au moyen d'une neuvième résistance R9 comprise entre 500 kOhms et quelques MOhms. Sur notre exemple, elle est de 1MOmhs. Ces impulsions délivrent une tension moyenne (aux fréquences de mesure considérées) qui constitue un second offset en parallèle avec le circuit d'offset manuel de VR1 et R7. Le microcontrôleur peut alors être configuré pour agir sur le rapport cyclique des impulsions PWM pour annuler les courants de fuite sur l'entrée inverseuse de OP1.

L'invention n'est pas limitée aux modes de réalisation précédemment décrits en référence aux figures et des variantes pourraient être envisagées sans sortir du cadre de l'invention.

## Revendications

1. Dispositif pour la mesure d'un courant par intégration, ledit dispositif comportant :
- un premier amplificateur opérationnel OP1 comportant une première entrée inverseuse, le courant à mesurer étant appliqué sur ladite première entrée inverseuse ;
- un condensateur d'intégration disposé entre la première entrée inverseuse du premier amplificateur opérationnel OP1 et la sortie de ce premier amplificateur opérationnel ;
- un générateur de courant actif connecté à la première entrée inverseuse du premier amplificateur opérationnel OP1, ce générateur de courant étant configuré pour :
- dans un premier état de mesure du dispositif, compenser les courants de fuite du dispositif ;
- dans un second état de réinitialisation du dispositif, générer un courant apte à remettre la charge du condensateur d'intégration à sa valeur initiale Q₀ ;
ledit dispositif étant **caractérisé en ce que** le second état de réinitialisation est déclenchée par une valeur de charge du condensateur d'intégration sensiblement égale à une valeur maximale Q_{Max} qu'elle peut avoir, ledit dispositif comportant :
- des moyens de commande configurés pour :
- mémoriser un état initial de charge Q₀ du condensateur d'intégration, correspondant à une tension V_{C0} en sortie du premier amplificateur opérationnel ;
- placer le dispositif dans l'état de mesure et l'y maintenir jusqu'à ce que la charge du condensateur d'intégration atteigne sensiblement Q_{Max}, correspondant à une tension V_{CMax} en sortie du premier amplificateur opérationnel ;
- lorsque la charge du condensateur d'intégration atteint sensiblement Q_{Max}, correspondant à une tension V_{CMax} en sortie du premier amplificateur opérationnel, placer le dispositif dans l'état de réinitialisation jusqu'à ce que la charge du condensateur d'intégration atteigne sensiblement Q₀.

2. Dispositif selon la revendication 1 **caractérisé en ce que** le générateur de courant actif comporte un deuxième amplificateur opérationnel OP2 monté en suiveur, ledit deuxième amplificateur opérationnel OP2 comportant en outre une réaction positive au moyen d'une première résistance R5 de valeur supérieure à 500 MOhms.

3. Dispositif selon la revendication 2 **caractérisé en ce que** la sortie de l'amplificateur OP2 du générateur de courant est reliée, après une résistance R10 de l'ordre de 1kOhm, à deux diodes D1 et D2 connectées comme suit :
- pour D1, connectée au point commun des diodes D1 et D2 et à R10 par sa cathode, l'anode est reliée via une résistance de protection de faible valeur R11 à un niveau logique bas lorsque le circuit est dans son état de mesure, et un niveau logique haut lorsque le circuit est dans son état de réinitialisation et qu'on veut injecter dans C5 un courant dans un premier sens ;
- pour D2, connectée au point commun des diodes D1 et D2 et à R10 par son anode, la cathode est reliée à un niveau logique haut lorsque le circuit est dans son état de mesure, et un niveau logique bas lorsque le circuit est dans son état de réinitialisation et qu'on veut injecter dans C5 un courant dans un second sens.

4. Dispositif selon la revendication 3 **caractérisé en ce que** les moyens de commande comportent un microcontrôleur apte à commander le passage d'un courant de réinitialisation de la première capacité C5 dans un sens ou dans l'autre grâce aux diodes D1 et D2, et **en ce que** les niveaux logiques auxquels doivent être portées l'anode de D1 via R11, et la cathode de D2 sont appliqué chacun par une sortie logique du microcontrôleur.

5. Dispositif selon l'une quelconque des revendications précédentes **caractérisé en ce qu'**il peut basculer dans un état d'amplificateur de transimpédance grâce à un interrupteur électronique SW1 dont le contact central est reliée à l'extrémité de R5 non reliée à l'entrée non inverseuse du deuxième amplificateur opérationnel OP2, et permet de connecter ce contact soit sur le point commun entre la première diode D1 et la deuxième diode D2 pour obtenir un fonctionnement du circuit en mesureur de courant par intégration, soit sur la sortie de OP1 pour obtenir un fonctionnement du circuit en amplificateur de transimpédance, cet interrupteur électronique étant commandable par le microcontrôleur.

6. Dispositif selon l'une quelconque des revendications 3 à 4 **caractérisé en ce qu'**il comporte un moyen de mesure des dérives thermiques T dudit dispositif, ledit moyen de mesure des dérives thermiques étant relié à une entrée du microcontrôleur.

7. Système pour la mesure d'un courant par intégration, ledit système comportant :
- une chambre d'ionisation dans laquelle circule le courant ; et
- un dispositif pour la mesure du courant par intégration selon l'une quelconque des revendications précédentes.

## Patentansprüche

1. Vorrichtung zum Messen eines Stroms durch Integration, wobei die Vorrichtung aufweist:
- einen ersten operativen Verstärker OP1, aufweisend einen ersten invertierenden Eingang, wobei der zu messende Strom auf den ersten invertierenden Eingang angewendet wird;
- einen Integrationskondensator, der zwischen dem ersten invertierenden Eingang des ersten operativen Verstärkers OP1 und dem Ausgang dieses ersten operativen Verstärkers angeordnet ist;
- einen Wirkstromgenerator, der an den ersten invertierenden Eingang des ersten operativen Verstärkers OP1 angeschlossen ist, wobei dieser Stromgenerator ausgelegt ist, um:
- in einem ersten Messzustand der Vorrichtung die Leckströme der Vorrichtung auszugleichen;
- in einem zweiten Reinitialisierungszustand der Vorrichtung einen Strom zu erzeugen, der imstande ist, die Last des Integrationskondensators auf ihren Ausgangswert Qo zurückzustellen;
wobei die Vorrichtung **dadurch gekennzeichnet ist, dass** der zweite Reinitialisierungszustand von einem Lastwert des Integrationskondensators ausgelöst wird, der etwa gleich einem Maximalwert Q_{Max} ist, den er annehmen kann, wobei die Vorrichtung aufweist:
- Steuermittel, die ausgelegt sind, um:
- einen Ausgangslastzustand Qo des Integrationskondensators zu speichern, der einer Spannung Vco am Ausgang des ersten operativen Verstärkers entspricht;
- die Vorrichtung in den Messzustand zu platzieren und dort zu halten, bis die Last des Integrationskondensators etwa Q_{Max} erreicht, was einer Spannung Q_{CMax} am Ausgang des ersten operativen Verstärkers entspricht;
- wenn die Last des Integrationskondensators etwa Q_{Max} erreicht, was einer Spannung V_{cMax} am Ausgang des ersten operativen Verstärkers entspricht, die Vorrichtung in den Reinitialisierungszustand zu platzieren, bis die Last des Integrationskondensators etwa Q₀ erreicht.

2. Vorrichtung nach Anspruch 1, **dadurch gekennzeichnet, dass** der Wirkstromgenerator einen zweiten operativen Verstärker OP2 aufweist, der als Folger montiert ist, wobei der zweite operative Verstärker OP2 ferner eine positive Reaktion mittels eines ersten Widerstands R5 mit einem Wert über 500 MOhm aufweist.

3. Vorrichtung nach Anspruch 2, **dadurch gekennzeichnet, dass** der Ausgang des Verstärkers OP2 des Stromgenerators nach einem Widerstands R10 in der Größenordnung von 1 kOhm mit zwei Dioden D1 und D2 verbunden ist, die wie folgt angeschlossen sind:
- für D1, angeschlossen am gemeinsamen Punkt der Dioden D1 und D2 und an R10 durch seine Kathode, wobei die Anode über einen Schutzwiderstand von geringem Wert R11 mit einem niedrigen logischen Niveau verbunden ist, wenn der Stromkreis in seinem Messzustand ist, und mit einem hohen logischen Niveau, wenn der Stromkreis in seinem Reinitialisierungszustand ist und man in C5 einen Strom in einer ersten Richtung einspeisen möchte;
- für D2, angeschlossen am gemeinsamen Punkt der Dioden D1 und D2 und an R10 durch seine Anode, wobei die Kathode mit einem hohen logischen Niveau verbunden ist, wenn der Stromkreis in seinem Messzustand ist, und mit einem niedrigen logischen Niveau, wenn der Stromkreis in seinem Reinitialisierungszustand ist und man in C5 einen Strom in einer zweiten Richtung einspeisen möchte.

4. Vorrichtung nach Anspruch 3, **dadurch gekennzeichnet, dass** die Steuermittel einen Mikrocontroller aufweisen, der imstande ist, den Durchgang eines Reinitialisierungsstroms von der ersten Kapazität C5 in einer Richtung oder in der anderen dank der Dioden D1 und D2 zu steuern, und dass die logischen Niveaus, auf die die Anode von D1 über R11 und die Kathode von D2 gebracht werden müssen, auf jede durch einen logischen Ausgang des Mikrocontrollers angewendet werden.

5. Vorrichtung nach einem der vorangehenden Ansprüche, **dadurch gekennzeichnet, dass** sie dank eines elektronischen Schalters SW1, dessen zentraler Kontakt mit dem Ende von R5 verbunden ist, das nicht mit dem nicht invertierenden Eingang des zweiten operativen Verstärkers OP2 verbunden ist, in einen Transimpedanzverstärkerzustand umschalten kann, und erlaubt, diesen Kontakt entweder an den gemeinsamen Punkt zwischen der ersten Diode D1 und der zweiten Diode D2 anzuschließen, um eine Funktionsweise des Stromkreises als Strommesser durch Integration zu erhalten, oder an den Ausgang von OP1, um eine Funktionsweise des Stromkreises als Transimpedanzverstärker zu erhalten, wobei dieser elektronische Schalter durch den Mikrocontroller steuerbar ist.

6. Vorrichtung nach einem der Ansprüche 3 bis 4, **dadurch gekennzeichnet, dass** sie ein Messmittel der thermischen Abweichungen T der Vorrichtung aufweist, wobei das Messmittel der thermischen Abweichungen mit einem Eingang des Mikrocontrollers verbunden ist.

7. System zum Messen eines Stroms durch Integration, wobei das System aufweist:
- eine lonisierungskammer, in der der Strom fließt; und
- eine Vorrichtung zum Messen des Stroms durch Integration nach einem der vorangehenden Ansprüche.

## Claims

1. Device for measuring current by means of integration, said device comprising:
- a first operational amplifier OP1 comprising a first inverting input, with the current to be measured being applied on said first inverting input;
- an integration capacitor arranged between the first inverting input of the first operational amplifier OP1 and the output of this first operational amplifier;
- an active current source connected to the first inverting input of the first operational amplifier OP1, with this current source being configured to:
∘ in a first measurement state of the device, compensate for leakage current of the device;
∘ in a second reset state of the device, generate a current which can return the charge of the integration capacitor to its initial value Qo;
said device being **characterized in that** the second reset state is triggered by a charge value of the integration capacitor substantially equal to a maximum value Q_{Max} that it can have, said device comprising:
- means for controlling configured to:
∘ memorise a Qo initial charge state of the integration capacitor, corresponding to a voltage Vco at the output of the first operational amplifier;
∘ place the device in the measurement state and keep it there until the charge of the integration capacitor substantially reaches Q_{Max}, corresponding to a voltage V_{CMax} at the output of the first operational amplifier;
- when the charge of the integration capacitor substantially reaches Q_{Max}, corresponding to a voltage V_{CMax} at the output of the first operational amplifier, place the device in the reset state until the charge of the integration capacitor substantially reaches Qo.

2. Device according to claim 1 **characterised in that** the active current source comprises a second operational amplifier OP2 connected as a follower, said second operational amplifier OP2 further comprising a positive reaction by means of a first resistor R5 with a value greater than 500 MOhms.

3. Device according to claim 2 **characterised in that** the output of the amplifier OP2 of the current source is connected, after a resistor R10 of about 1 kOhm, to two diodes D1 and D2 connected as follows:
- for D1, connected to the common point of the diodes D1 and D2 and to R1 by its cathode, the anode is connected via a protective resistor of low value R11 to a low logic level when the circuit is in its measurement state, and a high logic level when the circuit is in its reset state and when it is desired to inject into C5 a current in a first direction;
- for D2, connected to the common point of the diodes D1 and D2 and to R10 by its anode, the cathode is connected to a high logic level when the circuit is in its measurement state, and a low logic level when the circuit is in its reset state and when it is desired to inject into C5 a current in a second direction.

4. Device according to claim 3 **characterised in that** the means for controlling comprise a microcontroller which can control the passing of a reset current of the first capacitor C5 in one direction or in the other thanks to the diodes D1 and D2, and **in that** the logic levels to which must be brought the anode of D1 via R11, and the cathode of D2 are each applied by a logic output of the microcontroller.

5. Device as claimed in any preceding claim **characterised in that** it can switch into an transimpedance amplifier state thanks to an electronic switch SW1 of which the central contact is connected to the end of R5 not connected to the non-inverting input of the second operational amplifier OP2, and makes it possible to connect this contact either on the common point between the first diode D1 and the second diode D2 in order to obtain an operation of the circuit as a current measurer by means of integration, or on the output of OP1 in order to obtain an operation of the circuit as a transimpedance amplifier, with this electronic switch being controllable by the microcontroller.

6. Device according to any of claims 3 to 4 **characterised in that** it comprises a means for measuring heat drifts T of said device, said means for measuring heat drifts being connected to an input of the microcontroller.

7. System for measuring current by means of integration, said system comprising:
- an ionisation chamber wherein the current circulates; and
- a device for measuring current by means of integration as claimed in any preceding claim.
